# EUROPÄISCHE PATENTSCHRIFT

(11) **EP 1 456 949 B1**
(45) Veröffentlichungstag und Bekanntmachung des Hinweises auf die Patenterteilung: **14.02.2007**
(21) Anmeldenummer: 02795152.4
(22) Anmeldetag: 11.12.2002
(51) Int. Cl.: H03K 5/01, H03K 6/04, H03K 4/94

(54) **SCHALTUNGSANORDNUNG ZUR BEREITSTELLUNG EINES AUSGANGSSIGNALS MIT EINSTELLBARER FLANKENSTEILHEIT**
CIRCUIT ARRANGEMENT FOR THE PROVISION OF AN OUTPUT SIGNAL WITH ADJUSTABLE FLANK PITCH
CIRCUIT POUR METTRE EN FORME UN SIGNAL DE SORTIE A PENTE AJUSTABLE

(30) Priorität: 21.12.2001 DE 10163461
(43) Veröffentlichungstag der Anmeldung: 15.09.2004
(73) Patentinhaber: austriamicrosystems AG, 8141 Unterpremstätten (AT)
(72) Erfinder: DEUTSCHMANN, Bernd, A-8010 Graz (AT); FRAISS, Gottfried, A-8663 Veitsch (AT)
(74) Vertreter: Epping - Hermann - Fischer
(86) Internationale Anmeldenummer: PCT/EP2002/014067
(87) Internationale Veröffentlichungsnummer: WO 2003/055071

(56) Entgegenhaltungen:
- EP-A- 0 952 668
- DE-A- 19 604 394
- US-A- 4 752 704

## Beschreibung

Die vorliegende Erfindung betrifft eine Schaltungsanordnung zur Bereitstellung eines Ausgangssignals mit einstellbarer Flankensteilheit.

Bei integrierten Schaltkreisen besteht normalerweise die Notwendigkeit, elektromagnetische Störemissionen zu verringern. Besonders bei Betrieb mit hochfrequenten, digitalen Signalen tritt aufgrund der steilen Signalflanken eine verhältnismäßig große, sowohl abgestrahlte als auch leitungsgebundene Störemission auf. Damit jedoch elektronische Systeme andere elektronische Systeme nicht unzulässig in deren Funktionsweise beeinträchtigen, sind regulatorische Maßnahmen wie das Festlegen von Grenzwerten getroffen, welche die sogenannte elektromagnetische Verträglichkeit verschiedener Systeme untereinander gewährleisten sollen. Die elektromagnetische Verträglichkeit (EMV) bezieht sich dabei sowohl auf Festlegungen der zulässigen Störemissionen, als auch auf Festlegungen bezüglich der erforderlichen Störfestigkeit. Eine Möglichkeit, hochfrequente Signalanteile im Frequenzspektrum eines Digitalsignals zu verringern, besteht darin, die Flankensteilheit der digitalen Signale zu reduzieren. Es wird daher angestrebt, die Flankensteilheit sowohl von ansteigenden, als auch von abfallenden Signalflanken so zu reduzieren, daß EMV-Standards oder EMV-Spezifikationen eingehalten werden können und die zuverlässige Funktion der Schaltungen sichergestellt ist.

Auf der anderen Seite werden bei den heute eingesetzten, schnellen digitalen Signalverarbeitungen beispielsweise in digitalen Signalprozessoren die Digitalsignale so schnell wie möglich geschaltet, oft im Bereich weniger hundert Picosekunden, wodurch der beschriebene große, hochfrequente Spektralanteil der Signale bedingt ist. Weiterhin unterliegen integrierte Schaltungen zur schnellen digitalen Signalverarbeitung üblicherweise der Forderung nach geringem Flächenbedarf auf einem Chip sowie geringer Stromaufnahme im Betrieb.

In der Druckschrift US 6,225,844 B1 ist eine Ausgangsstufe angegeben, welche stabil mit geringer Flankensteilheit betreibbar ist. Die angegebene Ausgangsstufe umfaßt zwei zwischen einem Bezugs- und einem Versorgungspotentialanschluß bezüglich ihrer Laststrecken parallel geschaltete CMOS-Inverterstufen, an denen ein Ausgangssignal mit reduzierter Flankensteilheit ableitbar ist. Während die erste der beiden Eingangsstufen unmittelbar vom Eingangssignal angesteuert wird, ist zur Ansteuerung der Gate-Elektroden der Transistoren der zweiten Transistor-Inverterstufe eine zusätzliche Steuerschaltung zur Beeinflussung der Flankensteilheit vorgesehen, welche ermöglicht, daß die beiden Transistoren der zweiten Ausgangsstufe gezielt zu- oder abschaltbar sind. Da zur Ansteuerung der zweiten Ausgangsstufe Schwellwerte der Transistoren eingesetzt werden, kann mit dem beschriebenen Prinzip lediglich eine zweistufige Schaltungsanordnung aufgebaut werden.

In dem Dokument US 5,140,194 A ist ebenfalls eine Schaltungsanordnung zur Reduzierung der Flankensteilheit eines Ausgangssignals angegeben. Auch hierbei sind mehrere, parallel geschaltete CMOS-Inverter-Ausgangsstufen vorgesehen. Zur Ansteuerung der unterschiedlichen Inverterstufen werden jeweils Verzögerungszeiten erzeugt. Das Erzeugen der Verzögerungszeiten erfolgt gemäß dem vorgeschlagenen Prinzip mit RC-Zeitkonstanten. Damit ist jedoch der Nachteil verbunden, stark toleranzbehaftete und verhältnismäßig chipflächenintensive Widerstände einsetzen zu müssen. Alternativ ist gemäß Dokument D2 ebenfalls vorgeschlagen, anstelle der RC-Glieder Verzögerungsglieder einzusetzen, welche jedoch ebenfalls aufwendig zu implementieren sind. Der Nachteil, die Zeitkonstanten für jede vorgesehene ausgangsseitige Inverterstufe einzeln einstellen und einzeln schaltungstechnisch implementieren zu müssen, bleibt dabei bestehen.

Die beschriebenen Schaltungsanordnungen haben weiterhin den Nachteil gemeinsam, daß die Steilheit des Ausgangssignals von den Eigenschaften des Eingangssignals abhängig ist.

Aufgabe der vorliegenden Erfindung ist es, eine Schaltungsanordnung zur Bereitstellung eines Ausgangssignals mit einstellbarer Flankensteilheit anzugeben, welche beliebig viele Inverterstufen zur beliebig genauen Einstellung der Flankensteilheit einzusetzen ermöglicht und welche weiterhin ein Ausgangssignal bereitstellt, dessen Steilheit der Flanken unabhängig von den Signaleigenschaften des Eingangssignals eingestellt werden kann.

Erfindungsgemäß wird die Aufgabe gelöst durch eine Schaltungsanordnung zur Bereitstellung eines Ausgangssignals mit einstellbarer Flankensteilheit, aufweisend:
- einen Eingang zum Zuführen eines Eingangssignals,
- einen Ausgang zum Abgreifen eines vom Eingangssignal abgeleiteten Ausgangssignals, dessen Signalflankensteilheit einstellbar ist,
- einen Rampensignalgenerator, der eingangsseitig mit dem Eingang der Schaltungsanordnung gekoppelt ist und der an seinem Ausgang ein trapezförmiges Signal bereitstellt,
- ein erstes Paar von Ausgangstransistoren, die mit ihren gesteuerten Strecken einerseits mit dem Ausgang der Schaltungsanordnung und andererseits mit einem Versorgungs- oder Bezugspotentialanschluß gekoppelt sind und die jeweils einen Steueranschluß haben, der mit dem Ausgang des Rampensignalgenerators unter Anwendung von zwei Schaltschwellen gekoppelt ist, und
- ein zweites Paar von Ausgangstransistoren, die mit ihren gesteuerten Strecken einerseits mit dem Ausgang der Schaltungsanordnung und andererseits mit einem Versorgungs- oder Bezugspotentialanschluß gekoppelt sind und die je einen Steueranschluß haben, der mit dem Ausgang des Rampensignalgenerators unter Anwendung von zwei weiteren Schaltschwellen gekoppelt ist.

Die Paare von Ausgangstransistoren umfassen bevorzugt je zwei komplementäre Transistoren. Diese sind bezüglich ihres Leitfähigkeitstyps komplementär, zum Beispiel ist je ein n-Kanal-und ein p-Kanal-Feldeffekttransistor vorgesehen.

Unter dem Begriff Paar von Ausgangstransistoren sind zwei Ausgangstransistoren verstanden, die gemeinsam eine Ausgangsstufe bilden, jedoch bevorzugt an ihren Steuerelektroden nicht gemeinsam, sondern unabhängig voneinander angesteuert werden.

Bevorzugt sind drei oder mehr Ausgangsstufen vorgesehen, die je zwei Ausgangstransistoren umfassen.

Die gesteuerten Strecken der Ausgangstransistoren, die gemeinsam ein Paar bilden, sind bevorzugt in Serie geschaltet. Diese Serienschaltungen sind parallel miteinander verschaltet. Die Verbindungsknoten der gesteuerten Strecken der Ausgangstransistoren, die gemeinsam ein Paar bilden, sind bevorzugt miteinander und mit dem Ausgang der Schaltungsanordnung verbunden.

Gemäß dem vorliegenden Prinzip steuert der Rampensignalgenerator mittels des trapezförmigen Signals das Ein- und Ausschaltverhalten des ersten und zweiten Paars von Ausgangstransistoren. Dabei wird für erstes und zweites Paar von Ausgangstransistoren sowie für eine beliebige Anzahl weiterer Paare von Ausgangstransistoren ein gemeinsames, von dem gemeinsamen Rampensignalgenerator erzeugtes trapezförmiges Signal verwendet.

Das Ausgangssignal des Rampengenerators ist ein trapezförmiges Signal mit verhältnismäßig geringer Steilheit sowohl in seiner ansteigenden wie auch in seiner abfallenden Signalflanke.

Vorteilhafterweise ist das trapezförmige Signal in seinen Eigenschaften wie insbesondere Flankensteilheit unabhängig vom Eingangssignal, insbesondere unabhängig von der Flankensteilheit des Eingangssignals.

Mit vorliegender Schaltungsanordnung kann ein Ausgangssignal mit einstellbarer Flankensteilheit erzeugt werden. Mit den unabhängig voneinander einstellbaren Schaltschwellen der Transistoren der Ausgangsstufen, welche in Abhängigkeit vom Signalverlauf des Rampensignals einzeln ein- oder ausgeschaltet werden, kann eine gewünschte Schaltreihenfolge und gewünschte Schaltverzögerungen exakt und unabhängig vom Verlauf des Eingangssignals der Schaltungsanordnung eingestellt werden. Insbesondere kann durch das sequenzielle Schalten der Ausgangstransistoren mit dem trapezförmigen Signal das Auftreten unerwünschter Querströme vermieden werden. Das vorliegende Prinzip ermöglicht demnach den Betrieb von Schaltungen in integrierter Schaltungstechnik mit hohen Signalgeschwindigkeiten bei zugleich verhältnismäßig geringen und insbesondere einstellbaren Störemissionen, denn durch Reduzieren der Flankensteilheit, welche einstellbar ist, werden sowohl die hochfrequenten Signalanteile im Spektrum der Digitalsignale als auch die damit verbundenen, hochfrequenten Störemissionen verringert. Für den Betrieb der vorliegenden Schaltungsanordnung mit einstellbarer Flankensteilheit ist vorteilhafterweise keine Vielzahl von aufwendig zu realisierenden Verzögerungsgliedern erforderlich.

Gemäß einer vorteilhaften Weiterbildung der vorliegenden Schaltungsanordnung sind zur Kopplung des Rampensignalgenerators mit dem ersten und dem zweiten Paar von Ausgangstransistoren jeweils Paare von Vortreibern vorgesehen zur Bereitstellung der gewünschten Schaltschwellen. Die Schaltschwellen können dabei mit Vorteil sowohl für die Ausgangstransistoren innerhalb eines Paars von Ausgangstransistoren, als auch zwischen den Paaren der Ausgangstransistoren unterschiedlich eingestellt werden und werden im Betrieb durch das trapezförmige Signal aktiviert.

Bevorzugt ist dabei je einem Ausgangstransistor je ein Vortreiber zugeordnet.

Die Vortreiber sind bevorzugt als Inverter ausgebildet.

Um eine erforderliche Treiberstärke mit einem kleinen Schwellwert zu kombinieren, wie es bei einigen der Ausgangstransistoren der Schaltungsanordnung vorgesehen sein kann, können bevorzugt auch mehrere Inverter zur Bildung eines Vortreibers in Serie geschaltet sein.

Die Inverter der Vortreiber werden gemäß dem beschriebenen Prinzip sequenziell mittels des trapezförmigen Signals mit rampenförmigem Verlauf ein- und ausgeschaltet. Die Vortreiber selbst treiben die Ausgangstransistoren.

Alternativ können die Vortreiber auch beispielsweise als Schmitt-Trigger ausgebildet sein.

Bei der beschriebenen Schaltungsanordnung können bevorzugt steuerbare Schalter zum schnellen Abschalten der Ausgangstransistoren vorgesehen sein, die mit ihren gesteuerten Strecken einen Steueranschluß der Ausgangstransistoren mit den Bezugs- oder Versorgungspotentialanschlüssen verbinden. Die steuerbaren Schalter ermöglichen ein schnelles Abschalten der jeweils zugeordneten Ausgangstransistoren und damit eine besonders geringe Verzögerungszeit des Ausgangssignals der Schaltungsanordnung bezüglich des Eingangssignals. So weitergebildet ist die Schaltungsanordnung besonders für schnelle, digitale Signalverarbeitung geeignet.

Die steuerbaren Schalter sind bevorzugt mit ihrer Steuerelektrode mit dem Eingang der Schaltungsanordnung, beispielsweise mit dem Eingang des Rampensignalgenerators verbunden.

Ein besonders schnelles Durchschalten des Eingangs der Schaltungsanordnung auf den Ausgang mit besonders geringer Signallaufzeit oder Signalverzögerung in der Schaltungsanordnung ist gemäß einer bevorzugten Weiterbildung der Schaltungsanordnung dadurch erzielbar, daß bei einem dritten Paar von Ausgangstransistoren die gesteuerten Strecken einerseits mit dem Ausgang der Schaltungsanordnung und andererseits mit Versorgungs- oder Bezugspotentialanschluß gekoppelt sind und die Steueranschlüsse der Ausgangstransistoren des dritten Paars je einen Steueranschluß haben, der mit dem Eingang des Rampensignalgenerators zur Zuführung des Eingangssignals gekoppelt ist.

Das dritte Paar von Ausgangstransistoren wird demnach nicht vom trapezförmigen Signal des Rampensignalgenerators angesteuert, sondern unmittelbar vom Eingangssignal selbst.

Der Rampensignalgenerator umfaßt bevorzugt ein kapazitives Bauelement, welches durch Auf- und Entladeeffekte die Signalrampe des rampenförmigen Singals bezüglich ihres Zeitverlaufs, insbesondere deren Flankensteileit bestimmt. Hierfür kann der Rampensignalgenerator beispielsweise eine Flip-Flop-ähnliche Struktur haben. Mit einem derart einfach aufgebauten Rampensignalgenerator ist vorteilhafterweise ein Rampenverlauf des trapezförmigen Signals erzielt, der unabhängig ist vom Verlauf des Eingangssignals.

Gemäß einer Weiterbildung der vorliegenden Schaltungsanordnung kann der Kapazitätswert des kapazitiven Bauelements des Rampensignalgenerators einstellbar ausgeführt sein, beispielsweise als Varaktordioden. Alternativ kann auch eine Kombination von verschiedenen, festen Kapazitätswerten vorgesehen sein, die zu- und abschaltbar sind. Diese können als interne oder als externe Kapazitäten realisiert sein.

Hierdurch kann durch einstellbaren Verlauf des trapezförmigen Signals eine zusätzliche Einstellmöglichkeit des Ausgangssignals der Schaltungsanordnung erzielt werden.

Weitere Einzelheiten und vorteilhafte Ausgestaltungen der Erfindung sind Gegenstand der Unteransprüche.

Die Erfindung wird nachfolgend an mehreren Ausführungsbeispielen anhand der Zeichnungen näher erläutert.

Es zeigen:
- Figur 1a: ein erstes Ausführungsbeispiel einer erfindungsgemäßen Schaltungsanordnung zur Bereitstellung eines Ausgangssignals mit einstellbarer Flankensteilheit anhand eines vereinfachten Blockschaltbildes,
- Figur 1b: den Verlauf des trapezförmigen Signals zur Ansteuerung der Ausgangstransistoren gemäß Figur 1a,
- Figur 2: eine beispielhafte Ausführungsform eines Rampensignalgenerators gemäß Figur 1a anhand eines Schaltbildes,
- Figur 3: die Zeitverläufe von Eingangssignal und Ausgangssignal einer Schaltungsanordnung gemäß Figur 1a,
- Figur 4: die Darstellung gemäß Figur 3, jedoch anhand einer Kurvenschar mit veränderlicher Steilheit des Eingangssignals bezüglich der ansteigenden Signalflanke,
- Figur 5a: eine Weiterbildung der Schaltungsanordnung gemäß Figur 1a mit schneller Abschaltung,
- Figur 5b: den Verlauf eines trapezförmigen Signals zur Ansteuerung der Ausgangstransistoren gemäß Figur 5a,
- Figur 6a: eine Weiterbildung der Schaltungsanordnung gemäß Figur 5a für geringere Signallaufzeiten,
- Figur 6b: den Verlauf eines trapezförmigen Signals zur Ansteuerung der Ausgangstransistoren gemäß Figur 6a und
- Figur 7: Zeitverläufe von Eingangssignal und Ausgangssignal bei Variation des Kapazitätswertes im Rampensignalgenerator.

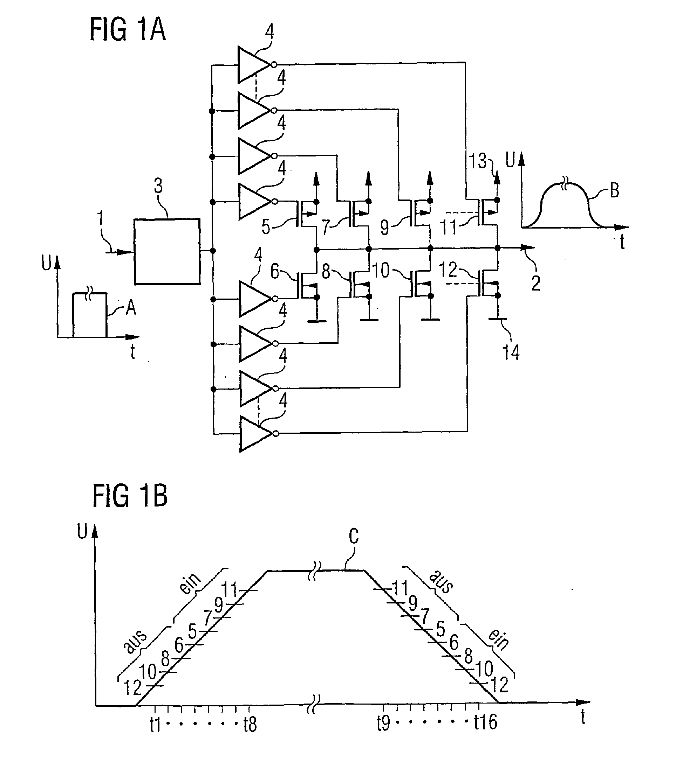

Figur 1a zeigt eine Schaltungsanordnung zur Bereitstellung eines Ausgangssignals B mit einstellbarer Flankensteilheit, umfassend einen Eingang 1 zum Zuführen eines Eingangssignals A und einen Ausgang 2 zum Abgreifen eines vom Eingangssignal A abgeleiteten Ausgangssignals B, dessen Signalflankensteilheit einstellbar ist. Weiterhin umfaßt die Schaltungsanordnung einen Rampensignalgenerator 3, der mit seinem Eingang mit dem Eingang 1 der Schaltungsanordnung verbunden ist und der an seinem Ausgang ein trapezförmiges Signal C mit verhältnismäßig langsam ansteigender und langsam abfallender Signalflanke, welche einen rampenförmigen Verlauf aufweisen, hat.

Der Ausgang des Rampensignalgenerators 3 ist mit einer Vielzahl von als Inverter ausgebildeten Vortreibern 4 jeweils an deren Eingang verbunden. Die Inverter 4 haben dabei unterschiedliche Schaltschwellen. Die Ausgänge der Vortreiber 4 sind mit je einem Gate-Anschluß eines Metal Oxide Semiconductor (MOS)-Feldeffekt-Transistors verbunden. Je zwei komplementäre MOS-Transistoren 5, 6; 7, 8; 9, 10; 11, 12 bilden je ein Paar von Ausgangstransistoren, wobei jedes Paar von Ausgangstransistoren eine Inverterstufe bildet. Die ausgangsseitigen Inverterstufen umfassen je einen p-Kanal-Transistor 5, 7, 9, 11, der mit seiner Laststrecke je einen Versorgungspotentialanschluß 13 mit dem Ausgang 2 der Schaltung koppelt und je einen N-Kanal-MOS-Transistor 6, 8, 10, 12, der mit seiner Laststrecke den Ausgang 2 mit einem Bezugspotentialanschluß 14 verbindet.

Die Funktionsweise der Schaltung gemäß Figur 1a wird nachfolgend anhand des Signalverlaufs der Spannung des rampenförmigen Signals C wie in Figur 1b dargestellt erläutert, welches ausgangsseitig am Rampensignalgenerator 3 bereitgestellt wird und dessen Zeitverlauf, insbesondere dessen Flankensteilheit, unabhängig ist vom Eingangssignal A. Das trapezförmige Signal C schaltet die Vielzahl von als Vortreiber verwendeten Inverterstufen 4 in Abhängigkeit von der Signalspannung und den Schaltschwellen der Inverter sequenziell ein und aus. Die Vortreiber 4 wiederum steuern die Ausgangstransistoren 5 bis 12 an. Der Signalverlauf des trapezförmigen Signals C zeigt Umschaltschwellen der hierfür unterschiedlich ausgelegten Inverter 4 anhand der Bezugszeichen der den Invertern 4 zugeordneten Transistoren 5 bis 12 von Figur 1a zu verschiedenen Zeitpunkten t1 bis t16.

Bei dem Schaltbild gemäß Figur 1a nehmen die Flächenverhältnisse der Ausgangstransistoren 5 bis 11 sowie 6 bis 12 jeweils von links nach rechts zu, was gleichbedeutend damit ist, daß die Ausgangstransistoren 11, 12 die größte Stromtreiberfähigkeit, und die Ausgangstransistoren 5, 6 die geringste Stromtreiberfähigkeit aufweisen. Die wirksamen Transistorflächen der Ausgangstransistoren sind also paarweise abgestuft zueinander vorgesehen mit dem Ziel, einen möglichst weichen Übergang des Ausgangssignals B von einem niedrigen auf einen hohen Signalpegel und umgekehrt zu erreichen.

Die Ansteuerung der Ausgangstransistoren 5 bis 12 mittels Vortreibern 4 mit unterschiedlichen Schaltschwellen durch ein gemeinsames trapezförmiges Signal C bietet den Vorteil, daß zum einen eine Vielzahl von Ausgangsstufen, das heißt Ausgangstransistoren vorgesehen werden kann je nach gewünschter Genauigkeit der Einstellung des Ausgangssignals B bezüglich seiner Flankensteilheit, daß zum anderen ein Aufbau mit geringer Chipfläche möglich ist und daß schließlich der Flankenverlauf des Ausgangssignals B unabhängig ist von demjenigen des Eingangssignals A, da das trapezförmige Signal C stets einen konstanten, einstellbaren Signalverlauf hat.

Die Vortreiber-Inverter 4, die die Ausgangstransistoren 5 bis 12 treiben, sind so ausgelegt, daß sie unterschiedliche Schwellspannungen haben. Jeder Inverter 4 wird eingeschaltet, wenn das Spannungsniveau des trapezförmigen Signals 3 seinen eingestellten Spannungsschwellwert erreicht und wieder abgeschaltet, wenn das Spannungsniveau des trapezförmigen Signals C unter diese eingestellte Schwellspannung fällt. Die Schwellspannungen der Inverter, welche die P-Kanal-Transistoren 5, 7, 9, 11 ansteuern, sind unterschiedlich zu den Schwellspannungen derjenigen Inverter 4 eingestellt, die die N-Ausgangstransistoren 6, 8, 10, 12 ansteuern, mit dem Zweck, Querströme zu vermeiden. Wie bereits erläutert, kann anstelle eines Inverters 4 eine Vielzahl in Serie geschalteter Inverter vorgesehen sein, beispielsweise drei in Serie geschaltete Inverter, von denen der eingangsseitige Inverter zur Erzeugung der gewünschten Schwellspannung und der ausgangsseitige Inverter zum Treiben des Ausgangstransistors, der an ihn angeschlossen ist, ausgelegt ist.

Ein weiterer Vorteil kann dadurch erzielt werden, daß der ausgangsseitige Inverter 4 besonders klein bezüglich seiner Transistorfläche ausgelegt wird. Hierdurch ergibt sich eine zusätzliche Verringerung der Steilheit des Ausgangssignals B, denn der Gate-Anschluß des zugeordneten Ausgangstransistors 5 bis 12 wird verhältnismäßig langsam aufgeladen. Hierdurch wird der Ausgangstransistor 5 bis 12 gezwungen, daß eine lange Zeit bis zum vollständigen Durchschalten des Ausgangstransistors vergeht.

Die Größe, das heißt die Transistorfläche und damit die Treiberfähigkeit der Ausgangstransistorpaare 5, 6; 7, 8; 9, 10; 11, 12 zueinander ist unterschiedlich ausgelegt. Das Ausgangstransistorpaar 5, 6 weist die geringste wirksame Transistorfläche auf. Die benachbarten Ausgangstransistoren 7, 8 haben eine größere Transistorfläche als die Transistoren 5, 6, die Ausgangstransistoren 9, 10 wiederum haben eine größere wirksame Transistorfläche als die Ausgangstransistoren 7, 8 und so weiter. Beim Einschalten des Ausgangssignals, also beim Übergang von Low nach High, werden die Ausgangstransistoren 12, 10, 8, 6 der Reihe nach, beginnend mit dem größten, ausgeschaltet. Anschließend werden die Ausgangstransistoren 5, 7, 9, 11, beginnend mit dem kleinsten Ausgangstransistor, der Reihe nach eingeschaltet. Das Schalten eines kleinen Ausgangstransistors 5, 6 hat die Wirkung, daß ein kleiner Transistor eine längere Zeit braucht, um eine externe Lastkapazität zu laden und zu entladen als ein großer. In jeder Ausgangsstufe 5, 6; 7, 8; 9, 10; 11, 12 wird eine externe Last ein wenig weiter aufgeladen oder entladen, so lange, bis die Ausgangsspannung am Ausgang 2 den gewünschten Spannungswert erreicht, der dem entsprechenden Logikpegel, High oder Low, zugeordnet ist.

Das sequenzielle Ein- und Ausschalten der Ausgangstransistoren 5 bis 12 hat wie erwähnt zusätzlich den Vorteil, daß Querströme auf ein Minimum reduziert werden. Hierdurch wird nicht nur die Störabstrahlung der Schaltung verbessert, sondern auch die Leistungsaufnahme der Schaltung reduziert.

Soll beispielsweise das Ausgangssignal B vom Low- zu einem High-Pegel ansteigen, so geht auch das trapezförmige Signal C, welches über die Inverter 4 die Ausgangstransistoren 5 bis 12 ansteuert, von Low nach High. Diese Signalrampe steigt dabei langsam über die Zeit an und erreicht schließlich die Schwellspannungen der Inverter 4. Zuerst wird die Schwellspannung des Inverters 4, der dem größten N-Kanal-Ausgangstransistor 12 zugeordnet ist, erreicht. Dieser Ausgangstransistor 12 schaltet aus. Anschließend erreicht das trapezförmige Signal C die Schwellspannung des nächstkleineren N-Kanal-Transistors 10 und auch der Transistor 10 schaltet ab. Ebenso werden auch nacheinander die Ausgangstransistoren 8 und 6 abgeschaltet, so lange, bis alle N-Kanal-Ausgangstransistoren ausgeschaltet sind. Mit weiterem Ansteigen des trapezförmigen Signals C wird die Schwellspannung des dem kleinsten P-Kanal-Transistor 5 zugeordneten Inverters 4 erreicht und der Ausgangstransistor 5 wird eingeschaltet. Daran anschließend wird die Schwellspannung des nächstgrößeren P-Kanal-Transistors 7 erreicht, der ebenfalls einschaltet. Daran anschließend werden auch die P-Kanal-Ausgangstransistoren 9 und 11 eingeschaltet, so lange, bis alle P-Kanal-Ausgangstransistoren eingeschaltet sind. Die gesamte Treiberfähigkeit, welche in der Lage ist, eine am Ausgang 2 angeschlossene Last in einen High-Pegel zu versetzen, wird definiert durch die Summe der Transistorflächen aller P-Kanal-Ausgangstransistoren der Schaltung und die Treiberfähigkeit in den Low-Zustand durch die Summe der Transistorflächen aller N-Kanal-Ausgangstransistoren.

In Analogie hierzu erfolgt das Treiben des Ausgangssignals B von High nach Low. Hierbei werden zunächst die P-Kanal-Ausgangstransistoren nacheinander ausgeschaltet und anschließend die N-Kanal-Ausgangstransistoren nacheinander eingeschaltet. Das aufeinanderfolgende Einschalten von Transistoren von zunehmender Transistorfläche führt zu einer langsam ansteigenden oder abfallenden Flanke des Ausgangssignals B. Ein großer Vorteil hierbei gegenüber bekannten Ausgangstreibern ist, daß der Spitzenstrom zum Laden und Entladen externer Lasten bei vorliegendem Prinzip in eine Vielzahl von Stromzweigen aufgespalten wird, welche einen verhältnismäßig geringen Strom treiben. Neben dem geringeren Laststrom des einzelnen Ausgangstransistors ist es ein weiterer Vorteil, daß die längere Zeit, die erforderlich ist zum Umschalten des Ausgangs 2 zu einem geringeren Strom-Gradienten di/dt führt, wodurch die Abstrahlung elektromagnetischer Energie von integrierten Halbleiterschaltkreisen reduziert wird. Ein weiterer Vorteil liegt im verringerten Überschießen des Ausgangssignals durch die gezeigte Ansteuerung.

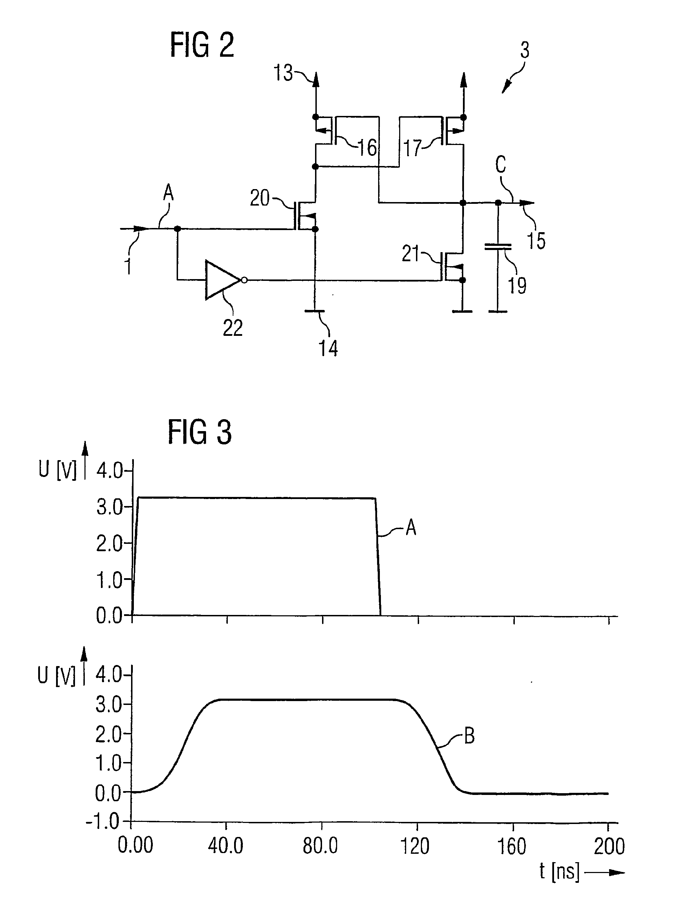

Figur 2 zeigt das Schaltbildes eines möglichen Aufbaus des Rampensignalgenerators 3 aus Figur 1a. Am Eingang 1 wird dem Rampensignalgenerator 3 das Eingangssignal A zugeführt. Am Ausgang 15 des Rampensignalgenerators 3 stellt dieser das trapezförmige Signal C bereit. Der Rampensignalgenerator 3 umfaßt zwei über Kreuz miteinander verkoppelte Transistoren 16, 17, welche als p-Kanal-MOS-Transistoren ausgebildet sind und mit ihren Laststrecken einerseits mit dem Versorgungspotentialanschluß 13 gekoppelt sind. Der Transistor 17 ist über eine Kapazität 19 mit dem Bezugspotentialanschluß 14 verbunden. Der Steueranschluß oder Gate-Anschluß des Transistors 16 ist mit einem Lastanschluß des Transistors 17 verbunden, während der Steueranschluß des Transistors 17 mit einem Lastanschluß des Transistors 16 verbunden ist. Parallel zum Kondensator 19 ist ein Schalttransistor 21 mit seiner Laststrecke geschaltet, welcher mit seiner gesteuerten Strecke mit dem Eingang 1 gekoppelt ist. Dem Steueranschluß des Transistors 20 ist dabei das Eingangssignal A unverändert, dem Steueranschluß des Transistors 21 ist das Eingangssignal A hingegen invertiert zugeführt. Hierfür ist ein Inverter 22 zwischen Eingang 1 und dem Steueranschluß des Transistors 21 geschaltet.

Der Schaltung des Rampensignalgenerators liegt das Prinzip zugrunde, mit einem konstanten Strom die Lastkapazität 19 aufzuladen. Die Kapazität 19 muß nicht zwingend als externe Kapazitäten, sondern kann bevorzugt als Gate-Kapazität von MOS-Transistoren ausgelegt sein. Die Kapazität 19 wird mittels des PMOS-Transistors 17 aufgeladen und mittels des NMOS-Transistors 21, welcher parallel zur Kapazität 19 geschaltet ist, entladen. Die Schaltung gemäß Figur 2 entspricht damit einem Flip-Flop-Prinzip. Vorteilhafterweise zeigt der Rampensignalgenerator 3 keinen oder zumindest einen sehr geringen Ruhestrom. Ströme fließen nur, wenn der Kondensator 19 geladen oder entladen wird. Weiterhin weist der Rampensignalgenerator 3 vorteilhafterweise eine geringe Stromaufnahme auf.

Figur 3 zeigt anhand der Verläufe der Signalspannung über der Zeit das Eingangssignal A mit einer ansteigenden und einer abfallenden Flanke und das Ausgangssignal B ebenfalls anhand ansteigender und abfallender Flanke. Man erkennt, daß mit vorliegender Schaltung der gewünschte Effekt, nämlich ein verhältnismäßig langsamer Anstieg der Signalflanke und ein verhältnismäßig langsames Abfallen der Signalflanke mit weichen Übergängen und mit geringem Überschwingen erzielt ist bei zugleich verhältnismäßig geringer Verzögerungszeit.

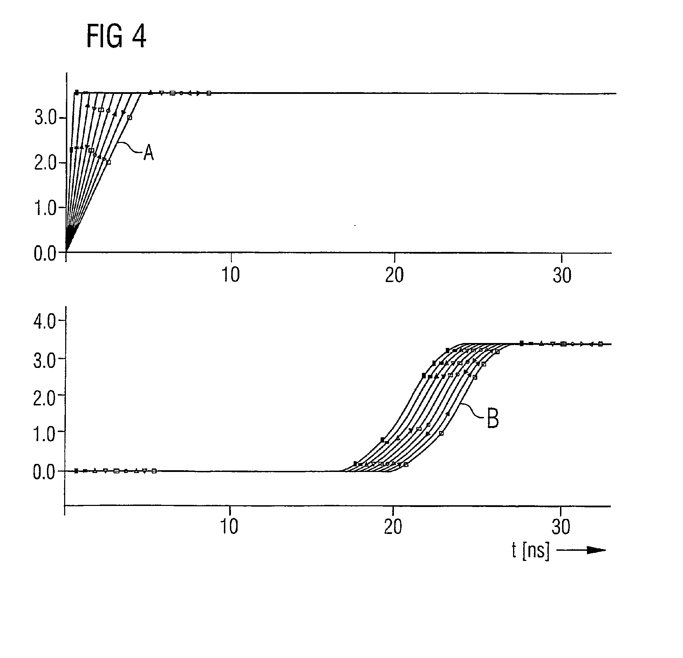

Figur 4 zeigt ebenfalls anhand der Signalverläufe über der Zeit ein Schaubild der ansteigenden Flanke des Eingangssignals A und darunter bei zeitlich sehr hoher Auflösung die Anstiegsflanke des Ausgangssignals B gemäß vorliegendem Prinzip. Die Signalverläufe von Ein- und Ausgangssignal A, B sind als Kurvenschar dargestellt, wobei als Scharparameter die Steilheit der Anstiegsflanke des Eingangssignals A gewählt ist. Man erkennt deutlich, daß unabhängig von der Flankensteilheit des Eingangssignals A der Verlauf der ansteigenden Flanke des Ausgangssignals B jeweils gleich ist und insbesondere die gleiche Flankensteilheit aufweist. Lediglich die Verzögerungszeit ist geringfügig abhängig von der Flankensteilheit des Eingangssignals A.

Figur 5a zeigt eine Weiterbildung der Schaltung gemäß Figur 1a. Diese entspricht in Aufbau und vorteilhafter Wirkungsweise weitgehend derjenigen von Figur 1a, weist jedoch zusätzlich zu den in Figur 1a gezeigten Bauelementen Transistoren zum schnellen Abschalten 23, 24 der Ausgangstransistoren 5 bis 12 auf. Dabei ist je ein PMOS-Transistor 23 zum schnellen Abschalten der PMOS-Ausgangstransistoren 5, 7, 9, 11 mit seinem Steueranschluß mit dem Eingang 1 und mit seiner Laststrecke einerseits mit dem Versorgungspotentialanschluß 13 und andererseits mit je einem Steueranschluß eines zugeordneten Ausgangstransistors 5, 7, 9, 11 verbunden. Weiterhin ist jedem NMOS-Ausgangstransistor 6, 8, 10, 12 je ein NMOS-Abschalttransistor 24 zugeordnet, welche mit ihren gesteuerten Strecken jeweils einerseits mit dem Bezugspotentialanschluß 14 und andererseits mit je einem Steuereingang des zugeordneten N-Kanal-Ausgangstransistors 6, 8, 10, 12 und mit ihren Steueranschlüssen mit dem Eingang 1 der Schaltung verbunden sind.

Die Weiterbildung gemäß Figur 5a mit den Abschalttransistoren 23, 24 bietet den Vorteil, daß eine besonders geringe Verzögerungszeit des Ausgangssignals B gegenüber dem Eingangssignal A mit verhältnismäßig geringem Aufwand erzielt ist.

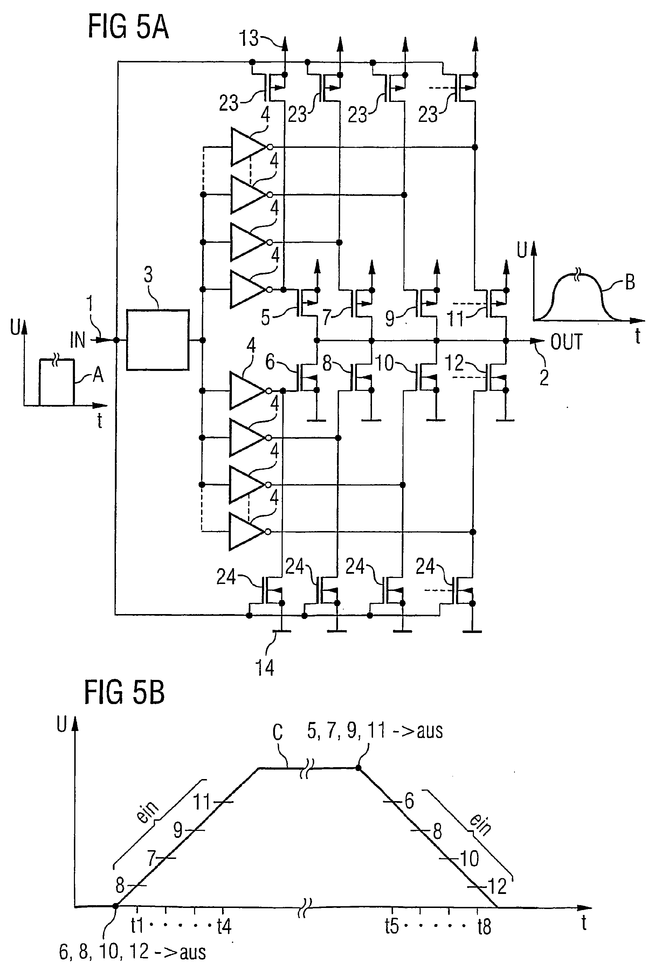

Figur 5b zeigt den Verlauf des trapezförmigen Signals C zur Ansteuerung der Schaltung gemäß Figur 5a in weitgehender Übereinstimmung mit dem Signalverlauf von Figur 1b. Lediglich die Umschaltschwellen der den Transistoren 5 bis 12 zugeordneten Inverter 4 und die Zeitpunkte t1 bis t8 sind an die Weiterbildung mit den Abschalttransistoren 23, 24 gemäß Figur 5a angepaßt.

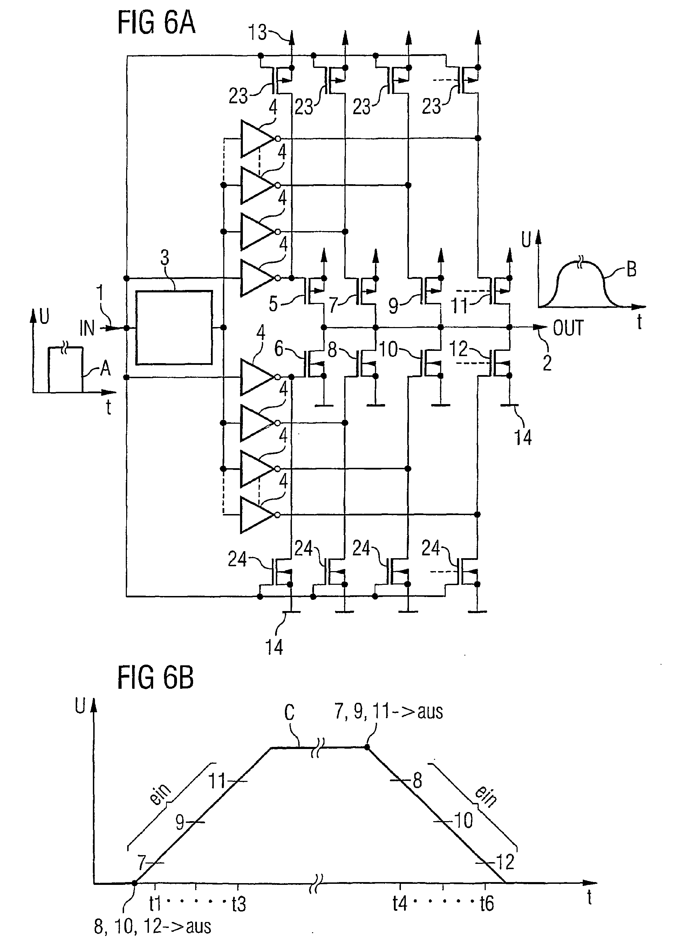

Figur 6a zeigt eine Weiterbildung der Schaltung gemäß Figur 5a, welche dieser in Aufbau und Funktion weitgehend entspricht. Lediglich in der Ansteuerung der Ausgangstransistoren 5, 6, welche die kleinste Transistorfläche aller Ausgangstransistoren 5 bis 12 haben, unterscheidet sich Figur 6a mit Vorteil von der Schaltung gemäß Figur 5a. Hier sind die Inverter 4, welche den Ausgangstransistoren 5, 6 zu deren Ansteuerung zugeordnet sind, mit ihren Eingängen nicht mit dem Ausgang des Rampensignalgenerators 3, sondern mit dem Eingang des Rampensignalgenerators 3 und damit mit dem Eingang 1 der Schaltung verbunden. Die den übrigen Ausgangstransistoren 7 bis 12 zugeordneten Inverter 4 sind wie zuvor erläutert auch bei der Schaltung gemäß Figur 6a weiterhin mit dem Ausgang des Rampensignalgenerators 3 verbunden. Dies ermöglicht eine noch weitere Reduzierung von Signallaufzeiten und Phasenverzögerungen des Ausgangssignals B gegenüber dem Eingangssignal A.

Das Schaubild gemäß Figur 6b zeigt den Verlauf des trapezförmigen Signals C über der Zeit t anhand der Signalspannung, welche mit der Darstellung des trapezförmigen Signals C in Figuren 1b und 5b weitgehend übereinstimmt. Lediglich die Umschaltschwellen der den Transistoren 7 bis 12 zugeordneten Inverter 4 und die Zeitpunkte t1 bis t6 sind an die Weiterbildung mit den Abschalttransistoren 23, 24 gemäß Figur 6a sowie die direkte Ansteuerung der dritten Ausgangstransistoren 5, 6 mit dem Eingangssignal A angepaßt.

Bei den Schaltungen gemäß Figuren 5a und 6a werden die Ausgangstransistoren 5 bis 12 wie bei der Schaltung gemäß Figur 1a sequenziell ein- und ausgeschaltet. Die Weiterbildung gemäß Figur 5a und 6a mit den Transistoren zum schnellen Abschalten 23, 24 ermöglicht das schnelle Abschalten, wodurch mit Vorteil ein schnelleres Aufeinanderfolgen der Schalthandlungen der Ausgangstransistoren erfolgen kann, da Querströme durch das schnelle Abschalten nicht fließen können.

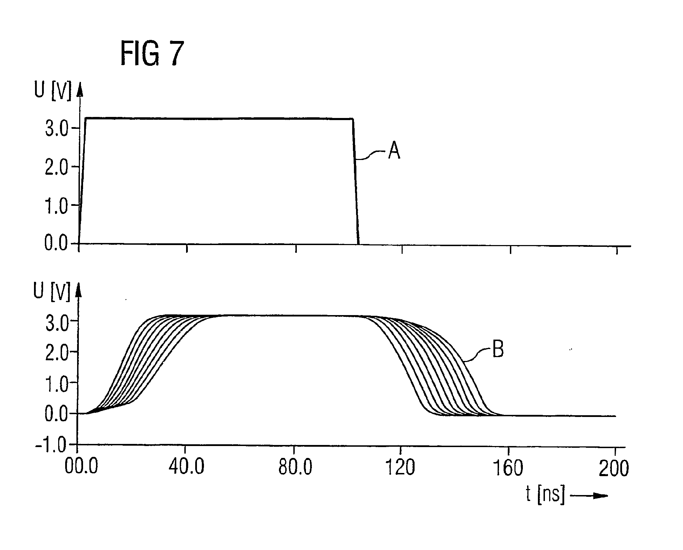

Figur 7 zeigt den Signalverlauf der Spannung des Ausgangssignals B anhand einer Kurvenschar in Abhängigkeit vom Signalverlauf der Spannung des Eingangssignals A bei einer Schaltung gemäß Figur 1a, 5a oder 6a gemäß einer Simulation. Dabei wird jedoch als Scharparameter der Kapazitätswert des kapazitiven Bauteils 19 des Rampensignalgenerators gemäß Figur 2 variiert. Das Ausgangssignal B mit der steilsten Flanke ist bei dem kleinsten Kapazitätswert, dasjenige mit der langsamsten Flanke bei dem größten Kapazitätswert aufgenommen. Dazwischen wurde der Kapazitätswert in diskreten Schritten erhöht.

## Patentansprüche

1. Schaltungsanordnung zur Bereitstellung eines Ausgangssignals (B) mit einstellbarer Flankensteilheit, aufweisend:
- einen Eingang (1) zum Zuführen eines Eingangssignals (A),
- einen Ausgang (2) zum Abgreifen eines vom Eingangssignal (A) abgeleiteten Ausgangssignals (B), dessen Signalflankensteilheit einstellbar ist,
- einen Rampensignalgenerator (3), der eingangsseitig mit dem Eingang der Schaltungsanordnung (1) gekoppelt ist und der an seinem Ausgang ein trapezförmiges Signal (C) bereitstellt,
- ein erstes Paar von Ausgangstransistoren (11, 12), die mit ihren gesteuerten Strecken einerseits mit dem Ausgang (2) der Schaltungsanordnung und andererseits mit einem Versorgungs- oder Bezugspotentialanschluß (13, 14) gekoppelt sind und die jeweils einen Steueranschluß haben, der mit dem Ausgang des Rampensignalgenerators (3) unter Anwendung von je einer Schaltschwelle gekoppelt ist, und
- ein zweites Paar von Ausgangstransistoren (9, 10), die mit ihren gesteuerten Strecken einerseits mit dem Ausgang der Schaltungsanordnung (2) und andererseits mit einem Versorgungs- oder Bezugspotentialanschluß (13, 14) gekoppelt sind und die je einen Steueranschluß haben, der mit dem Ausgang des Rampensignalgenerators (3) unter Anwendung von je einer Schaltschwelle gekoppelt ist.

2. Schaltungsanordnung nach Anspruch 1,
**dadurch gekennzeichnet , daß**
zur Kopplung des Rampensignalgenerators (3) mit den Steueranschlüssen der Ausgangstransistoren des ersten Paars je ein Vortreiber (4) vorgesehen ist zur Bereitstellung von je einer Schaltschwelle und daß zur Kopplung des Rampensignalgenerators (3) mit den Steueranschlüssen der Ausgangstransistoren des zweiten Paars je ein Vortreiber (4) vorgesehen ist zur Bereitstellung je einer Schaltschwelle.

3. Schaltungsanordnung nach Anspruch 2,
**dadurch gekennzeichnet, daß**
die Vortreiber (4) als Inverter ausgebildet sind.

4. Schaltungsanordnung nach einem der Ansprüche 1 bis 3,
**dadurch gekennzeichnet , daß**
steuerbare Schalter (23, 24) zum schnellen Abschalten der Ausgangstransistoren (5 bis 12) vorgesehen sind, die mit ihren gesteuerten Strecken einen Steueranschluß des jeweils zugeordneten Ausgangstransistors (5 bis 12) mit dem Bezugs- oder Versorgungspotentialanschluß (13, 14) verbinden.

5. Schaltungsanordnung nach Anspruch 4,
**dadurch gekennzeichnet , daß**
die steuerbaren Schalter (23, 24) je eine Steuerelektrode haben, die mit dem Eingang (1) der Schaltungsanordnung verbunden ist.

6. Schaltungsanordnung nach einem der Ansprüche 1 bis 5,
**dadurch gekennzeichnet , daß**
ein drittes Paar von Ausgangstransistoren vorgesehen ist (5, 6), wobei die Ausgangstransistoren (5, 6) mit ihren gesteuerten Strecken einerseits mit dem Ausgang der Schaltungsanordnung (2) und andererseits mit dem Versorgungs- oder Bezugspotentialanschluß (13, 14) gekoppelt sind und wobei die Ausgangstransistoren (5, 6) je einen Steueranschluß haben, der mit dem Eingang (1) des Rampensignalgenerators (3) zur Zuführung des Eingangssignals (A) gekoppelt ist.

7. Schaltungsanordnung nach einem der Ansprüche 1 bis 6,
**dadurch gekennzeichnet, daß**
der Rampensignalgenerator (3) so ausgebildet ist, daß das an seinem Ausgang bereitgestellte trapezförmige Signal (C) bei ansteigender und abfallender Flanke eine Steilheit hat, welche unabhängig vom Eingangssignal (A) ist.

8. Schaltungsanordnung nach Anspruch 7,
**dadurch gekennzeichnet , daß**
der Rampensignalgenerator (3) ein kapazitives Bauelement (19) zur Steuerung der Steilheit der ansteigenden und abfallenden Flanke des trapezförmigen Signals (C) aufweist.

9. Schaltungsanordnung nach Anspruch 8,
**dadurch gekennzeichnet, daß**
der Kapazitätswert des ersten kapazitiven Bauelements (19) einstellbar ist.

10. Schaltungsanordnung nach einem der Ansprüche 1 bis 9,
**dadurch gekennzeichnet, daß**
die wirksamen Transistorflächen der Ausgangstransistoren (5, 6; 7, 8; 9, 10; 11, 12) unterschiedlich groß sind.

## Claims

1. Circuit arrangement for providing an output signal (B) having an adjustable edge gradient, which has:
- an input (1) for supplying an input signal (A),
- an output (2) for tapping off an output signal (B) which is derived from the input signal (A) and whose signal edge gradient is adjustable,
- a ramp signal generator (3) whose input is coupled to the input of the circuit arrangement (1) and whose output provides a trapezoidal signal (C),
- a first pair of output transistors (11, 12) which have their controlled paths coupled firstly to the output (2) of the circuit arrangement and secondly to a supply or reference potential connection (13, 14) and which each have a control connection which is coupled to the output of the ramp signal generator (3) with the application of a respective switching threshold, and
- a second pair of output transistors (9, 10) whose controlled paths are coupled firstly to the output of the circuit arrangement (2) and secondly to a supply or reference potential connection (13, 14) and which have a respective control connection which is coupled to the output of the ramp signal generator (3) with the application of a respective switching threshold.

2. Circuit arrangement according to Claim 1,
**characterized in that**
in order to couple the ramp signal generator (3) to the control connections of the output transistors in the first pair a respective input driver (4) is provided for the purpose of providing a respective switching threshold and **in that** in order to couple the ramp signal generator (3) to the control connections of the output transistors in a second pair a respective input driver (4) is provided for the purpose of providing a respective switching threshold.

3. Circuit arrangement according to Claim 2,
**characterized in that**
the input drivers (4) are in the form of inverters.

4. Circuit arrangement according to one of Claims 1 to 3,
**characterized in that**
controllable switches (23, 24) for rapidly turning off the output transistors (5 to 12) are provided whose controlled paths connect a control connection of the respective associated output transistor (5 to 12) to the reference or supply potential connection (13, 14).

5. Circuit arrangement according to Claim 4,
**characterized in that**
the controllable switches (23, 24) have a respective control electrode which is connected to the input (1) of the circuit arrangement.

6. Circuit arrangement according to one of Claims 1 to 5,
**characterized in that**
a third pair of output transistors is provided (5, 6), where the output transistors (5, 6) have their controlled paths coupled firstly to the output of the circuit arrangement (2) and secondly to the supply or reference potential connection (13, 14) and where the output transistors (5, 6) have a respective control connection which is coupled to the input (1) of the ramp signal generator (3) for the purpose of supplying the input signal (A).

7. Circuit arrangement according to one of Claims 1 to 6,
**characterized in that**
the ramp signal generator (3) is in a form such that the trapezoidal signal (C) provided at its output has a rising and a falling edge with a gradient which is independent of the input signal (A).

8. Circuit arrangement according to Claim 7,
**characterized in that**
the ramp signal generator (3) has a capacitive component (19) for controlling the gradient of the rising and falling edges of the trapezoidal signal (C).

9. Circuit arrangement according to Claim 8,
**characterized in that**
the capacitance value of the first capacitive component (19) is adjustable.

10. Circuit arrangement according to one of Claims 1 to 9,
**characterized in that**
the effective transistor areas of the output transistors (5, 6; 7, 8; 9, 10; 11, 12) are of different magnitude.

## Revendications

1. Montage pour disposer d'un signal (B) de sortie à pente de front réglable, comprenant :
- une entrée (1) pour l'entrée d'un signal (A) d'entrée,
- une sortie (2) pour le prélèvement d'un signal (B) de sortie, qui est dérivé du signal (A) d'entrée et dont la pente de front peut être réglée,
- un générateur (3) de signal dé rampe, qui est couplé du côté entrée à l'entrée du montage (1) et qui met à disposition à sa sortie un signal (C) trapézoïdal,
- une première paire de transistors (11, 12) de sortie, qui sont couplés par leur section commandée d'une part à la sortie (2) du montage et d'autre part à une borne (13, 14) de potentiel d'alimentation ou de potentiel de référence et qui ont respectivement une borne de commande, qui est couplée à la sortie du générateur (3) de signal de rampe en utilisant respectivement un seuil de commutation, et
- une deuxième paire de transistors (9, 10) de sortie, qui sont couplés par leur section commandée d'une part à la sortie du montage (2) et d'autre part à une borne (13, 14) de potentiel d'alimentation ou de potentiel de référence et qui ont respectivement une borne de commande, qui est couplée à la sortie du générateur (3) de signal de rampe en utilisant respectivement un seuil de commutation.

2. Montage suivant la revendication 1,
**caractérisé en ce que**, pour coupler le générateur (3) de signal de rampe aux bornes de commande des transistors de sortie de la première paire, il est prévu respectivement un étage (4) d'attaque préalable pour mettre à disposition respectivement un seuil de commutation et **en ce que**, pour coupler le générateur (3) de signal de rampe aux bornes de commande des transistors de sortie de la deuxième paire, il est prévu respectivement un étage (4) d'attaque préalable pour la mise à disposition de respectivement un seuil de commutation.

3. Montage suivant la revendication 2,
**caractérisé en ce que** l'étage (4) d'attaque préalable est constitué en inverseur.

4. Montage suivant l'une des revendications 1 à 3,
**caractérisé en ce qu'**il est prévu, pour mettre rapidement à l'état bloqué les transistors (5 à 12) de sortie, des commutateurs (23, 24) qui peuvent être commandés et qui relient par leur section commandée une borne de commande du transistor (5 à 12) de sortie associée respectivement à la borne (13, 14) de potentiel de référence ou de potentiel d'alimentation.

5. Montage suivant la revendication 4,
**caractérisé en ce que** les commutateurs (23, 24) qui peuvent être commandés ont respectivement une électrode de commande, qui est reliée à l'entrée (1) du montage.

6. Montage suivant l'une des revendications 1 à 5,
**caractérisé en ce qu'**il est prévu une troisième paire de transistors de sortie, les transistors (5, 6) de sortie étant couplés, par leur section commandée, d'une part à la sortie du montage (2) et d'autre part à la borne (13, 14) de potentiel d'alimentation et de potentiel de référence et les transistors (5, 6) de sortie ayant respectivement une borne de commande qui est couplée à l'entrée (1) du générateur (3) de signal de rampe pour faire entrer le signal (A) d'entrée.

7. Montage suivant l'une des revendications 1 à 6,
**caractérisé en ce que** le générateur (3) de signal de rampe est tel que le signal (C) trapézoïdal mis à disposition à sa sortie a pour un front montant et descendant une pente qui est indépendante du signal (A) d'entrée.

8. Montage suivant la revendication 7,
**caractérisé en ce que** le générateur (1) de signal de rampe a un composant (19) capacitif pour régler la pente du front montant et descendant du signal (C) trapézoïdal.

9. Montage suivant la revendication 8,
**caractérisé en ce que** la valeur de la capacité du premier composant (19) capacitif est réglable.

10. Montage suivant l'une des revendications 1 à 9,
**caractérisé en ce que** les surfaces actives des transistors (5, 6, 7, 8, 9, 10, 11, 12) de sortie ont des valeurs différentes.
